(19) Europäisches Patentamt / European Patent Office / Office européen des brevets

(11) **EP 3 127 137 B1**

(12) **FASCICULE DE BREVET EUROPEEN**

(45) Date de publication et mention de la délivrance du brevet:
**12.08.2020 Bulletin 2020/33**

(51) Int Cl.:
***H01J 37/32*** *(2006.01)*

(21) Numéro de dépôt: **15725704.9**

(22) Date de dépôt: **26.03.2015**

(86) Numéro de dépôt international:
**PCT/FR2015/050765**

(87) Numéro de publication internationale:
**WO 2015/150665 (08.10.2015 Gazette 2015/40)**

(54) **PROCÉDÉ ET DISPOSITIF POUR GÉNÉRER UN PLASMA EXCITÉ PAR UNE ÉNERGIE MICRO-ONDE DANS LE DOMAINE DE LA RÉSONANCE CYCLOTRONIQUE ÉLECTRONIQUE**

VERFAHREN UND VORRICHTUNG ZUR ERZEUGUNG EINES MIKROWELLENPLASMA AUF DEM GEBIET DER ELEKTRONISCHEN ZYKLOTRONISCHEN RESONANZ

METHOD AND DEVICE FOR GENERATING A MICROWAVE PLASMA IN THE FIELD OF ELECTRONIC CYCLOTRONIC RESONANCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.04.2014 FR 1453000**

(43) Date de publication de la demande:
**08.02.2017 Bulletin 2017/06**

(73) Titulaires:
• **H.E.F.**
**42160 Andrezieux-Boutheon (FR)**
• **Luxembourg Institute of Science and Technology (LIST)**
**4362 Esch-sur-Alzette (LU)**

(72) Inventeurs:
• **BLANDENET, Olivier**
**F-38240 Meylan (FR)**
• **LAGARDE, Thierry Léon**
**F-38450 Vif (FR)**
• **CHOQUET, Patrick**
**F-57050 Longeville Les Metz (FR)**
• **DUDAY, David**
**L-2422 Luxembourg (LU)**

(74) Mandataire: **Cabinet Laurent & Charras**
**3 place de l'Hotel de Ville**
**CS 70203**
**42005 Saint-Etienne Cedex 1 (FR)**

(56) Documents cités:
**US-A1- 2002 172 780     US-A1- 2010 174 245**
**US-A1- 2011 079 582**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention se rattache au secteur technique de la production de plasma par résonance cyclotronique électronique (RCE) à partir d'un milieu gazeux.

Plus particulièrement, l'invention concerne le traitement de surface sous vide par plasma de tout type d'éléments filiformes tels que fils, tubes, fibres et plus généralement de tout produit dont la longueur est très importante par rapport au diamètre. L'élément filiforme étant entraîné linéairement en continu.

Par traitement de surface sous vide par plasma on entend nettoyage, décapage, activation greffage de fonctions ou revêtement de la surface par exemple par PECVD (dépôt physique en phase vapeur assisté par plasma) de l'élément filiforme.

On connaît de nombreuses solutions techniques pour réaliser des applicateurs micro-ondes pour le traitement de différents types de pièces. On peut citer par exemple, à titre indicatif et non limitatif, l'enseignement du brevet EP 1075168 qui concerne un procédé et un dispositif de production de plasmas élémentaires en vue de créer un plasma uniforme pour une surface d'utilisation. On peut citer également l'enseignement du brevet FR 2 922 358 qui concerne un procédé de traitement de surface d'au moins une pièce au moyen de sources élémentaires de plasma par résonance cyclotronique électronique. Les différentes solutions relevant de ces brevets sont particulièrement adaptées pour le traitement de grande surface ou de lots de pièces placées les unes à côté des autres et présentant généralement de multiples faces à traiter.

Selon l'état antérieur de la technique en utilisant un applicateur micro-onde avec embout magnétique, il apparait que le plasma est généré en bout de chaque aimant créant une zone dense de plasma. Il est connu également que pour générer un plasma micro-onde à basse pression, on utilise l'effet de la résonance cyclotronique électronique. La probabilité de chocs à haute vitesse est considérablement accrue ce qui créé un plasma dense dans la zone RCE. Ainsi, pour une fréquence de 2,45 GHz , la zone RCE se trouve au niveau des lignes de champ magnétique à 875 Gauss (G). Cette zone à 875 Gauss (G) se trouve autour de l'aimant.

Cette technologie d'applicateur plasma n'est pas adaptée pour le traitement en continu d'un fil (ou autre élément filiforme) nécessitant plusieurs applicateurs placés radialement et répétés plusieurs fois selon l'axe de défilement du fil à traiter pour obtenir une vitesse de défilement.

En effet le volume de plasma étant localisé ponctuellement en bout des applicateurs, il est nécessaire d'utiliser plusieurs applicateurs tout autour du fil (ou autre élément filiforme) pour garantir un dépôt uniforme axisymétrique. Une telle configuration nécessite une grande chambre de dépôt ce qui est consommateur de gaz et d'énergie. La multiplication des applicateurs et le manque de compacité rend ce système cher à la construction.

Il apparait donc que la juxtaposition de sources RCE classiques ne permet pas d'obtenir une configuration plasma favorable au dépôt sur un élément filiforme.

Pour le traitement de fils sous vide, selon l'état de la technique, on a proposé des traitements du type PVD (dépôt physique par phase vapeur), dépôt physique par phase vapeur comme il ressort par exemple de l'enseignement des documents WO 2005/095078, WO 2006/002673, FR 2667616 et EP 1231292, EP 1277874.

On connait également le brevet US 6,638,569 selon lequel on utilise une enceinte à vide classique et on soumet le fil à de multiples allers retours dans ladite enceinte de façon à exposer le maximum de surface du fil au plasma. Cette solution est peu efficace car la surface du fil est négligeable par rapport à la taille de l'enceinte et relève d'une relative complexité en mettant en œuvre des systèmes de renvoi fonctionnant sous vide.

A partir de cet état de la technique, le but recherché est de pouvoir réaliser sur tout type d'élément filiforme un traitement de surface sous vide par plasma tel que défini précédemment. Selon l'enseignement du brevet US 5,595,793, on dépose un revêtement par PECVD, par exemple un revêtement carboné, sur une fibre en utilisant une onde de plasma micro-onde de surface pour générer le plasma. Toutefois, cette solution est très limitée en application étant donné qu'elle ne peut fonctionner que sur des diélectriques et uniquement pour réaliser des dépôts isolants électriques. Autrement dit, il n'est pas possible de revêtir des fibres conductrices. Par ailleurs la fréquence du générateur doit être adaptée à la constante diélectrique de chaque matériau constituant la fibre. Le procédé n'est donc pas facilement transférable en passant d'un matériau à l'autre. Enfin le procédé est difficile à maitriser car au fur et à mesure que le dépôt se réalise, la constante diélectrique du matériau se modifie. Cette modification a un effet rétroactif sur le couplage de l'onde de surface avec le plasma.

Il ressort donc de cette analyse de l'état de la technique que la génération de plasma en utilisant les applicateurs, n'est pas adaptée pour le traitement en continu d'éléments filiformes, le volume de l'enceinte étant surdimensionné par rapport à la taille de l'élément, le gaz précurseur et l'énergie nécessaire étant important tandis que le plasma n'est pas généré à proximité du fil à revêtir. Il ressort également que les techniques de plasma micro-onde alternatives basées sur des ondes de surface sont limitées dans leurs applications et difficiles à mettre en œuvre.

On connait également le document US 2011/079582, dans lequel des aimants sont disposés dans une enceinte remplie de gaz à une pression inférieure à la pression atmosphérique. Un élément filiforme est supporté de manière fixe dans le tube, qui est mobile par rapport aux aimants. Une source d'énergie micro-onde est montée à l'extérieure de l'enceinte. Des anneaux de plasma sont créés autour des aimants, ce qui complique leur refroidissement. Ce dispositif ne permet pas de générer un plasma linéaire confiné autour de l'élément filiforme dans la chambre de traitement constitué par le tube.

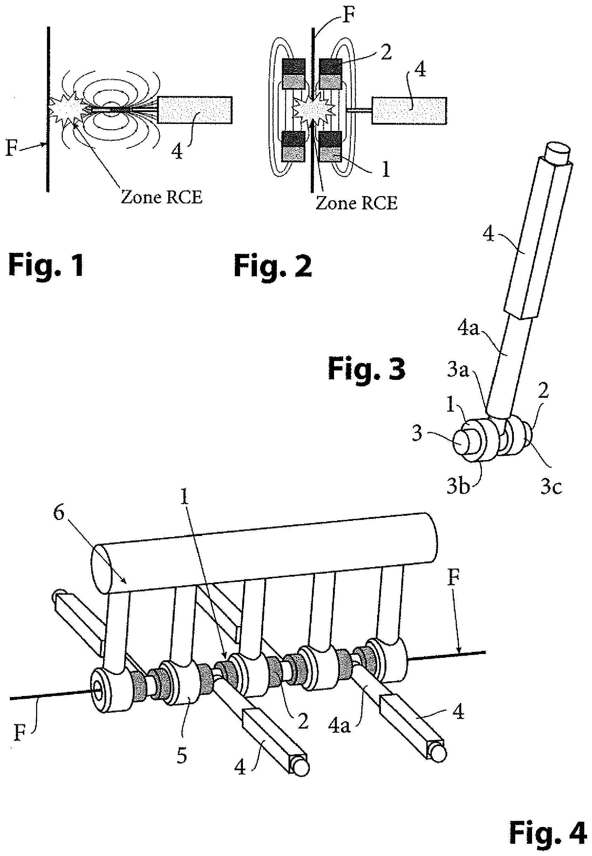

On connait enfin le document US 2002/172780, dans lequel des aimants non-annulaires sont montés de part et d'autre d'une chambre de traitement. Le déplacement de l'élément filiforme est effectué selon une direction parallèle aux lignes de champs magnétique, ce qui correspond à l'état de la technique montré à la figure 1 de la présente demande. Ce dispositif ne permet pas de garantir l'homogénéité du traitement sur l'élément filiforme.

L'invention s'est fixée pour but de remédier à ces inconvénients de manière simple, sure, efficace et rationnelle.

Le problème que se propose de résoudre l'invention est de permettre la génération d'un plasma linéaire confiné autour de tout type d'élément filiforme tel que défini, afin de minimiser le volume de la chambre et, par conséquent, l'investissement de consommation de gaz précurseur et de l'énergie nécessaire avec, pour objectif, de générer du plasma axisymétrique afin de garantir l'homogénéité du traitement sur la pièce, notamment par PECVD.

Pour résoudre un tel problème il a été conçu et mis au point un procédé conforme à la revendication 1.

L'invention concerne également un dispositif conforme à la revendication 4.

Il résulte de ces caractéristiques que la taille du dispositif (réacteur) est diminuée réduisant, par conséquent, les investissements permettant une diminution des consommations de gaz. On observe également que le plasma le plus dense se trouve sur le fil et non plus à proximité de ce dernier comme il ressort des solutions relevant de l'état antérieur de la technique, permettant ainsi une augmentation de vitesse de dépôt. Ces caractéristiques permettent également d'obtenir un dépôt homogène sur le fil compte tenu de l'axisymétrie des lignes de champ magnétique. A noter également, en ce qui concerne un traitement plasma afin de réaliser un dépôt chimique, que l'on obtient une meilleure utilisation du monomère et un encrassement moins rapide des parois du réacteur.

Selon d'autres caractéristiques :

- Les aimants annulaires peuvent être des aimants permanents, des bobines électromagnétiques, ou tout autre moyen permettant de créer un champ magnétique.
- L'applicateur micro-onde est disposé perpendiculairement à l'axe du tube.
- Le tube constitue un Té dont la branche médiane reçoit l'applicateur micro-onde tandis que les deux autres branches reçoivent les aimants de part et d'autre de ladite branche médiane.

Le dimensionnement des aimants annulaires doit être tel que le champ magnétique au centre du système entre deux aimants doit être égal au champ magnétique à la résonance cyclotronique électronique.

Par exemple si les aimants annulaires sont des bobines de rayon R comprenant n spires parcourues par un courant d'ampérage I, la distance D qui sépare ces deux bobines doit être telle que :

$$\frac{m.\,\omega}{e} = \frac{\mu_0.\,n.\,I}{R}\left(\frac{R^2}{R^2 + \left(\frac{D}{2}\right)^2}\right)^{3/2}$$

Où m est la masse des électrons, e leur charge et $\omega$ la pulsation de l'onde micro-onde.

On reconnaît dans le terme à droite de cette équation, l'équation de Biot et Savart.

Dans une forme de réalisation, le dispositif comprend plusieurs modules montés en série en alignement linéaire et reliés entre eux par une bague d'étanchéité. Chaque bague fait office soit de zone de pompage en étant reliée à un connecteur de pompage de gaz soit de zone de d'injection de gaz étant reliée à des dispositifs d'alimentation en gaz.

A noter que l'élément filiforme peut être électriquement polarisé afin de permettre un bombardement par les ions du plasma. Lorsque l'élément filiforme est polarisé, on peut réaliser une implantation ionique d'un gaz sur ledit élément.

L'invention est exposée ci-après plus en détail à l'aide des figures des dessins annexés dans lesquels :

- La fig. 1 montre un schéma de principe d'un réacteur selon l'état antérieur de la technique pour générer un dépôt sur un fil à revêtir ;
- La fig. 2 est une vue correspondant à la figure 1 montrant le principe du dispositif selon l'invention ;
- La fig. 3 est une vue en perspective d'un module de base du dispositif selon l'invention ;
- La fig. 4 est une vue en perspective montrant le montage de plusieurs modules du dispositif pour augmenter la vitesse de traitement,

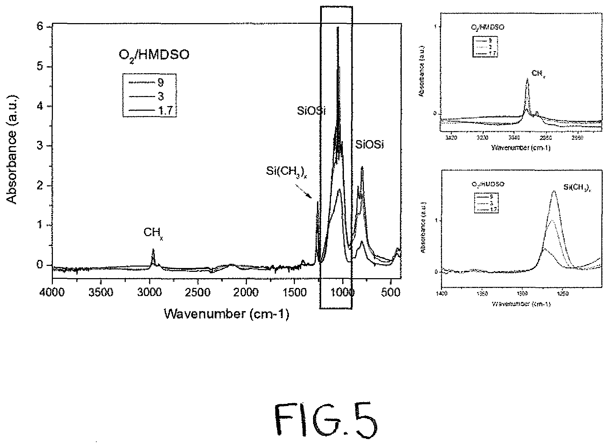

- La fig. 5 est une courbe des analyses FITR montrant de façon très classique que le dépôt s'approche d'autant plus du $SiO_2$ que la ration $O_2$/HMDSO est élevé.

Comme indiqué, l'invention trouve une application particulièrement avantageuse pour générer un plasma en vue du traitement de surface de tout type d'élément filiforme, y compris conducteur, du type fils, fibres, tubes, gaines... et plus généralement tout élément (F) présentant une longueur importante par rapport à son diamètre. Le but recherché selon l'invention est de traiter en continu l'élément (F) au « défilé », autrement dit, par entrainement linéaire du fil.

Selon l'invention, le dispositif ou réacteur comprend, au moins un module composé de deux dipôles magnétiques (1) et (2) disposés en regard et montés de préférence autour d'un tube (3), constituant une chambre de traitement. Chaque dipôle magnétique (1) et (2) est par exemple constitué par un aimant annulaire disposé concentriquement au tube (3). Ce montage facilite en particulier le refroidissement des aimants. En effet, contrairement aux applicateurs RCE décrits dans l'état de l'art, les aimants ne sont pas sous vide. L'élément (F) est engagé coaxialement au tube (3) et entraîné linéairement en continu par tout moyen connu et approprié. Un applicateur micro-onde (4), de tout type connu et approprié, est monté entre les deux aimants (1) et (2). L'applicateur micro-onde (4) est disposé perpendiculairement à l'axe du tube (3). De préférence les polarités en regard sont opposées afin que les lignes de champs soient parallèles à l'élément F. On renvoie à la figure 2 qui montre que le plasma au niveau de la zone RCE se trouve sur le fil. On observe également une axisymétrie des lignes de champ magnétiques (C) permettant de réaliser un dépôt homogène sur l'élément (F).

Dans une forme de réalisation, le tube (3) constitue un Té dont la branche médiane (3a) reçoit l'applicateur micro-onde (4) notamment, son guide coaxial (4a). Les deux autres branches (3b) et (3c) du Té reçoivent les aimants (1) et (2) de part et d'autre de la branche médiane (3a).

A partir de cette conception de base du dispositif, il est possible de monter en série et en alignement linéaire plusieurs modules comme le montre la figure (4). Dans cette configuration, la liaison entre les modules est assurée par une bague d'étanchéité (5) qui fait également office de zone de pompage en étant raccordée à un connecteur (6) de pompage de gaz. Dans cette configuration les gaz plasmagènes et éventuellement réactifs sont préférentiellement injectés en vis-à-vis des applicateurs micro-onde (injection non représentée sur la figure). Une configuration alternative à celle représentée consiste à ce que les bagues d'étanchéité font alternativement office de zone de pompage et de zone d'injection de gaz.

Le pompage est réparti entre le centre du réacteur et les extrémités droite et gauche de ce dernier. L'élément filiforme (F) est introduit linéairement dans la chambre de traitement résultant du tube constitué par un alignement linéaire et le montage en série des différentes branches (3b), (3c) des tubes et des bagues (5). Pour augmenter la vitesse de défilement de l'élément filiforme (F), il suffit de multiplier le nombre de modules.

A noter qu'il est possible d'injecter, dans chaque module, un précurseur adapté et de laminer les circuits de pompage pour régler les pressions de travail de chaque module.

Des essais ont été effectués avec des aimants en samarium Cobalt ($Sm_2Co_{17}$) sans pour cela exclure tout autre matériau pour engendrer un champ magnétique de 875 G tel que le Néodyme Fer Bore.

Ces essais ont été effectués selon deux configurations.

## Première configuration :

Les aimants ont les dimensions suivantes :

- diamètre interne 20 mm,
- diamètre externe 28 mm,
- épaisseur 20 mm, polarisation suivant l'épaisseur,
- distance entre les aimants 31, 5 mm
- polarités opposées entre les aimants.

## Deuxième configuration :

Les aimants ont les dimensions suivantes :

- diamètre interne 33,8 mm,
- diamètre externe 50 mm,
- épaisseur 25 mm, polarisation suivant l'épaisseur,
- distance entre les aimants 46 mm
- caractéristique du tube servant de chambre de traitement : DN25 soit 33,7 mm de diamètre extérieur
- polarités opposées entre les aimants.

Dans ces deux configurations :

- Les micro-ondes sont injectées au centre de l'espace entre les deux aimants. La profondeur de pénétration de l'injecteur micro-onde doit être optimisée pour faciliter l'amorçage et le fonctionnement du plasma.
- Les aimants sont à la pression atmosphérique. Les aimants sont refroidis par contact avec une enveloppe externe dans laquelle circule un fluide par exemple de l'eau. Les zones de pompage et les zones d'injection de gaz ont été alternées.
- Les aimants sont maintenus dans le système par trois vis de pression pour éviter qu'ils ne s'attirent.

Les avantages ressortent bien de la description, en particulier, on souligne et on rappelle :

- la génération d'un plasma linéaire confiné autour de l'élément à traiter afin de minimiser le volume de la chambre et par conséquent diminuer les investissements et la consommation du gaz précurseur et de l'énergie,
- la génération d'un plasma axisymétrique afin de garantir l'homogénéité du dépôt sur l'élément à traiter,
- la possibilité de traiter tout type d'éléments filiformes y compris conducteur du type fils, tubes, fibres et plus généralement tout produit dont la longueur est importante par rapport à son diamètre.

L'invention est définie par les revendications.
A titre d'exemple, on décrit ci-dessous des essais de dépôt de $SiO_x$ par PECVD ECR dans un réacteur selon la deuxième configuration

Premier procédé PECVD

- Débit de TMS (Tétraméthyl Silane) : 5 sccm
- Débit de d'O$_2$ (dioxygène) : 18 sccm
- Pression : 1,3.10$^{-2}$ mbar
- Puissance d'injection des micro-ondes : 100 W

Avec ce ratio O$_2$/TMS de 3,6 la vitesse de dépôt constatée entre les deux aimants au milieu de la chambre est de 250 nm/min.

La vitesse de dépôt est mesurée sur une plaque de silicium posée au centre du réacteur.

Deuxième procédé PECVD

- Pression : 1.10$^{-2}$ mbar
- Puissance d'injection des micro-ondes : 50 W

Utilisation d'un mélange O$_2$/HMDSO

| Ratio O$_2$/HMDSO | Vitesse de dépôt nm/min |
|---|---|
| 9 | 530 |
| 3 | 875 |
| 1,7 | 1100 |

**Revendications**

1. Procédé pour générer un plasma excité par une énergie micro-onde dans le domaine de la résonance cyclotronique électronique , RCE, pour réaliser un traitement de surface ou revêtement autour d'un élément filiforme (F) selon lequel:

   - on dispose au moins deux aimants annulaires (1, 2) constituant chacun un dipôle magnétique, à la pression atmosphérique, en regard et autour d'un tube (3) constituant une chambre de traitement,
   - on déplace linéairement en continu l'élément filiforme (F) à travers les au moins deux aimants annulaires (1, 2) et à travers le tube (3) constituant la chambre de traitement,
   - on introduit l'énergie micro-onde entre les au moins deux aimants annulaires (1, 2) via un applicateur micro-onde (4) monté entre les au moins deux aimants annulaires (1,2),
   - on génère un plasma linéaire confiné autour de l'élément filiforme (F) dans la chambre de traitement.

2. Procédé selon la revendication 1, dans lequel le traitement de surface est un nettoyage, un décapage, une fonctionnalisation, ou un greffage.

3. Procédé selon la revendication 1, dans lequel le revêtement est obtenu par PECVD, dépôt physique en phase vapeur assisté par plasma.

4. Dispositif pour générer un plasma autour d'un élément filiforme (F) entraîné linéairement en continu et comprenant des moyens de production d'une énergie micro-onde dans le domaine de la résonance cyclotronique électronique, RCE, et un applicateur micro-onde (4), le dispositif comprenant en outre un tube (3) constituant une chambre de traitement, au moins un module composé de deux aimants annulaires (1, 2) constituant chacun un dipôle magnétique, disposés à la pression atmosphérique, en regard et montés autour du tube (3); dispositif dans lequel le tube (3) et les deux aimants annulaires (1,2) sont configurés de sorte que l'élément filiforme (F) à traiter est déplaçable linéairement à travers les deux aimants annulaires (1, 2) et à travers le tube (3) constituant la chambre de traitement, et l'applicateur micro-onde (4) est monté entre les deux aimants annulaires (1, 2) pour introduire de l'énergie micro-onde entre les deux aimants annulaires (1, 2), générant ainsi lorsque le dispositif est utilisé, un plasma linéaire confiné autour de l'élément filiforme (F) dans la chambre de traitement.

5. Dispositif selon la revendication 4, dans lequel les aimants annulaires sont des aimants permanents.

6. Dispositif selon la revendication 4, dans lequel les aimants annulaires sont des bobines électromagnétiques.

7. Dispositif selon la revendication 4, dans lequel l'applicateur micro-onde (4) est disposé perpendiculairement à l'axe du tube (3).

8. Dispositif selon la revendication 4, dans lequel le tube (3) constitue un Té dont la branche médiane (3a) reçoit l'applicateur micro-onde tandis que les deux autres branches (3b, 3c) reçoivent les aimants annulaires (1, 2) de part et d'autre de ladite branche médiane (3a).

9. Dispositif selon l'une quelconque des revendications 4 à 8, comprenant plusieurs modules montés en série et en alignement linéaire et reliés entre eux par une bague d'étanchéité (5).

10. Dispositif selon la revendication 9, dans lequel chaque bague d'étanchéité (5) est reliée à un connecteur de pompage de gaz de telle sorte que chaque bague d'étanchéité fasse office de zone de pompage, lorsque le dispositif est utilisé.

11. Dispositif selon la revendication 9, dans lequel les bagues d'étanchéité (5) sont arrangées de sorte à faire alternativement office de zone de pompage et de zone d'injection de gaz, lorsque le dispositif est utilisé.

12. Dispositif selon l'une quelconque des revendications 4 à 11, dans lequel l'élément filaire (F) est électriquement polarisé afin de permettre un bombardement par les ions du plasma.

**Patentansprüche**

1. Verfahren zur Erzeugung eines erregten Plasmas durch Mikrowellenenergie auf dem Gebiet der Elektron-Zyklotron-Resonanz, EZR, zur Durchführung einer Oberflächenbehandlung oder Beschichtung eines fadenförmigen Elementes (F) nach dem:

   - mindestens zwei Ringmagnete (1, 2), die jeweils einen magnetischen Dipol bilden, werden bei Raumdruck gegenüber und um ein Rohr (3) angeordnet, das eine Behandlungskammer bildet,
   - das fadenförmige Element (F) wird kontinuierlich linear durch die mindestens zwei Ringmagnete (1, 2) durch das Rohr (3), das die Behandlungskammer bildet, verschoben,
   - die Mikrowellenenergie wird zwischen den mindestens zwei Ringmagneten (1, 2) über einen Mikrowellen-Applikator (4) angelegt, der zwischen den mindestens zwei Ringmagneten (1, 2) montiert ist,
   - es wird ein lineares Plasma erzeugt, das um das fadenförmige Element (F) in der Behandlungskammer herum begrenzt ist.

2. Verfahren nach Anspruch 1, bei dem es sich bei der Oberflächenbehandlung um Reinigen, Abbeizen, Funktionalisieren oder Pfropfen handelt.

3. Verfahren nach Anspruch 1, bei dem die Beschichtung durch PECVD, durch Plasma unterstütztes chemisches Dampfabscheiden, erfolgt.

4. Vorrichtung zur Erzeugung eines Plasmas um ein kontinuierlich, linear verschobenes, fadenförmiges Element (F) herum, welche Mittel zur Erzeugung von Mikrowellenenergie auf dem Gebiet der Elektron-Zyklotron-Resonanz, EZR, enthält, sowie einen Mikrowellen-Applikator, (4), die Vorrichtung enthält außerdem ein Rohr (3), das eine Behandlungskammer bildet, mindestens ein Modul, bestehend aus zwei Ringmagneten (1, 2), die jeweils einen magnetischen Dipol bilden, die dem Raumdruck ausgesetzt sind und gegenüberliegend und um das Rohr (3) montiert sind; Vorrichtung bei der das Rohr (3) und die beiden Ringmagnete (1,2) so konfiguriert sind, dass das zu behandelnde fadenförmige Element (F) linear durch die beiden Ringmagnete (1, 2) und durch das Rohr (3), das die Behandlungskammer bildet, verschoben werden kann und der Mikrowellen-Applikator (4) zwischen den beiden Ringmagneten (1, 2) montiert ist, um die Mikrowellenenergie zwischen den beiden Ringmagneten (1, 2) anzulegen, und so, wenn die Vorrichtung verwendet wird, ein lineares Plasma zu erzeugen, das um das fadenförmige Element (F) in der Behandlungskammer begrenzt ist.

5. Vorrichtung nach Anspruch 4, bei der die Ringmagnete Dauermagnete sind.

6. Vorrichtung nach Anspruch 4, bei der die Ringmagnete elektromagnetische Spulen sind.

7. Vorrichtung nach Anspruch 4, bei der der Mikrowellen-Applikator (4) senkrecht zur Rohrachse (3) angeordnet ist.

8. Vorrichtung nach Anspruch 4, bei der der das Rohr (3) ein T bildet, dessen mittlerer Ast (3a) den Mikrowellen-Applikator aufnimmt, während die beiden anderen Äste (3b, 3c) die Ringmagnete (1, 2) auf beiden Seiten dieses mittleren Astes (3a) aufnehmen.

9. Vorrichtung nach irgendeinem der Ansprüche 4 bis 8, die mehrere in Serie montierte und linear angeordnete Module enthält, die miteinander durch einen Dichtring (5) verbunden sind.

10. Vorrichtung nach Anspruch 9, bei der jeder Dichtring (5) mit einem Gas- Pump. Anschluss verbunden ist, so dass jeder Dichtring als Pumpzone dient, wenn die Vorrichtung verwendet wird.

11. Vorrichtung nach Anspruch 9, bei dem die Dichtringe so angeordnet sind, dass sie alternativ als Pumpzone oder als Gaseinspritzzone dienen können, wenn die Vorrichtung verwendet wird.

12. Vorrichtung nach irgendeinem der Ansprüche 4 bis 11, bei der das fadenförmige Element (F) elektrisch polarisiert wird, um einen Beschuss durch die Plasmaionen zu ermöglichen.

**Claims**

1. Process to generate a plasma excited by microwave energy in the field of electron cyclotron resonance, ECR, to execute a surface treatment or coating around a filiform element (F), according to which:

   - at least two annular magnets (1, 2), each constituting a magnetic dipole, are arranged at atmospheric pressure, facing each other, and around a tube (3) constituting a treatment chamber,
- the filiform element (F) is linearly and continuously moved through the at least two annular magnets (1, 2) and through the tube (3) forming the treatment chamber,
- microwave energy is introduced between the at least two annular magnets (1, 2) via a microwave applicator (4) mounted between the at least two annular magnets (1,2),
- a confined linear plasma is generated around the filiform element (F) in the treatment chamber.

2. Process according to claim 1, *wherein* the surface treatment is a cleaning, a scouring, a functionalisation, or a grafting.

3. Process according to claim 1, *wherein* the coating is obtained by PECVD (plasma-enhanced chemical vapour deposition).

4. Device to generate a plasma around a filiform element (F) driven linearly and continuously and comprising means of production of a microwave energy in the field of electron cyclotron resonance, ECR, and a microwave applicator (4), the device further comprising a tube (3) constituting a treatment chamber, at least one module composed of two annular magnets (1, 2), each constituting a magnetic dipole, arranged at atmospheric pressure, facing each other and mounted around the tube (3) ; device in which the tube (3) and the two annular magnets (1, 2) are configured in such a way that the filiform element (F) to be treated is linearly movable through the two annular magnets (1, 2) and through the tube (3) constituting the treatment chamber, and the microwave applicator (4) is mounted between the two annular magnets (1, 2) to introduce microwave energy between the two annular magnets (1, 2), thereby generating, when the device is in use, a linear plasma confined around the filiform element (F) in the treatment chamber.

5. Device according to claim 4, *wherein* the annular magnets are permanent magnets.

6. Device according to claim 4, *wherein* the annular magnets are electromagnet coils.

7. Device according to claim 4, *wherein* the microwave applicator (4) is arranged perpendicularly to the axis of the tube (3).

8. Device according to claim 4, *wherein* the tube (3) constitutes a Tee whose median branch (3a) receives the microwave applicator whereas the other two branches (3b, 3c) receive the annular magnets (1, 2) on each side of said median branch (3a).

9. Device according to any one of claims 4 to 8, comprising several modules mounted in series and in linear alignment and connected together by a sealing ring (5).

10. Device according to claim 9, wherein each sealing ring (5) is connected to a gas pumping connector such that each sealing ring acts as a pumping zone, when the device is in use.

11. Device according to claim 9, wherein the sealing rings (5) are arranged so as to act alternately as a gas pumping zone and injection zone when the device is in use.

12. Device according to any one of claims 4 to 11, *wherein* the filiform element (F) is electrically polarised to allow a bombardment from the plasma ions.

Zone RCE

**Fig. 1**

Zone RCE

**Fig. 2**

**Fig. 3**

**Fig. 4**

FIG.5

**EP 3 127 137 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1075168 A
- FR 2922358
- WO 2005095078 A
- WO 2006002673 A
- FR 2667616
- EP 1231292 A
- EP 1277874 A
- US 6638569 B
- US 5595793 A
- US 2011079582 A
- US 2002172780 A